# EUROPÄISCHE PATENTSCHRIFT

(11) **EP 2 289 107 B1**
(45) Veröffentlichungstag und Bekanntmachung des Hinweises auf die Patenterteilung: **02.01.2019**
(21) Anmeldenummer: 09761404.4
(22) Anmeldetag: 29.05.2009
(51) Int. Cl.: H01L 31/0224, H01L 31/068

(54) **SOLARZELLE UND VERFAHREN ZU DEREN HERSTELLUNG**
SOLAR CELL AND METHOD FOR THE PRODUCTION THEREOF
CELLULE SOLAIRE ET PROCÉDÉ DE FABRICATION

(30) Priorität: 11.06.2008 DE 102008027780
(43) Veröffentlichungstag der Anmeldung: 02.03.2011
(73) Patentinhaber: Fraunhofer-Gesellschaft zur Förderung der angewandten Forschung e.V., 80686 München (DE)
(72) Erfinder: BIRO, Daniel, 79106 Freiburg (DE); CLEMENT, Florian, 79108 Freiburg (DE); SCHULTZ-WITTMANN, Oliver, Sunnyvale, CA 94085, (US)
(74) Vertreter: Lemcke, Brommer & Partner Patentanwälte Partnerschaft mbB
(86) Internationale Anmeldenummer: PCT/EP2009/003859
(87) Internationale Veröffentlichungsnummer: WO 2009/149841

(56) Entgegenhaltungen:
- EP-A1- 0 881 694
- WO-A2-2008/045511
- JP-A- 5 048 123
- JP-A- 2008 010 746
- GEE J M ET AL: "Emitter wrap-through solar cell", PROCEEDINGS OF THE PHOTOVOLTAIC SPECIALISTS CONFERENCE. LOUISVILLE, MAY 10 - 14, 1993; [PROCEEDINGS OF THE PHOTOVOLTAIC SPECIALISTS CONFERENCE], NEW YORK, IEEE, US LNKD- DOI:10.1109/PVSC.1993.347173, Bd. CONF. 23, 10. Mai 1993 (1993-05-10), Seiten 265-270, XP010113396, ISBN: 978-0-7803-1220-3
- WARABISAKO T ET AL: "Bifacial multicrystalline silicon solar cells", PROCEEDINGS OF THE PHOTOVOLTAIC SPECIALISTS CONFERENCE. LOUISVILLE, MAY 10 - 14, 1993; [PROCEEDINGS OF THE PHOTOVOLTAIC SPECIALISTS CONFERENCE], NEW YORK, IEEE, US LNKD- DOI:10.1109/PVSC.1993.347044, Bd. CONF. 23, 10. Mai 1993 (1993-05-10), Seiten 248-251, XP010113205, ISBN: 978-0-7803-1220-3

## Beschreibung

Die Erfindung betrifft eine Solarzelle nach dem Oberbegriff des Anspruchs 1 sowie ein Verfahren zu deren Herstellung nach Anspruch 12.

Bei einer Solarzelle werden in einem Halbleitersubstrat positive und negative Ladungen (Elektronen und die dazu korrespondierenden "Löcher") durch einfallende elektromagnetische Strahlung getrennt und zwei voneinander getrennten Kontaktierungspunkten zugeführt, so dass durch einen externen Stromkreis elektrische Leistung abgegriffen werden kann.

Typischerweise besteht das Halbleitersubstrat aus einem flachen Siliziumwafer, der eine p-Dotierung aufweist. Dieser p-dotierte Dotierbereich wird auch Basis genannt. In der Basis stellen die Löcher Majoritätsladungsträger und die Elektronen Minoritätsladungsträger dar.

Eine typische Solarzelle weist an der Vorderseite des Siliziumwafers einen n-dotierten Dotierbereich auf, den Emitter. Zwischen Emitter und restlichem, p-dotiertem Substrat (der Basis) entsteht ein pn-Übergang, an dem die Ladungsträger getrennt werden. Im Emitter stellen die Elektronen Majoritäten und die Löcher Minoritäten dar.

Typische Solarzellen weisen an der Vorderseite eine gitterförmige und an der Rückseite eine ganzflächige Metallisierung auf. Die Vorderseitenmetallisierung ist mit dem Emitter elektrisch leitend verbunden, so dass die Elektronen im Emitter über die Vorderseitenmetallisierung in den äußeren Stromkreis gelangen können. Ebenso ist die Rückseitenmetallisierung mit dem p-dotierten Dotierbereich der Solarzelle elektrisch leitend verbunden, so dass die Löcher über die Rückseitenmetallisierung ebenfalls in den äußeren Stromkreis gelangen können.

Die Vorderseitenmetallisierung weist mindestens eine Kontaktierungsfläche auf, welche eine ausreichende Größe besitzt, so dass mittels eines Zellverbinders die Vorderseitenmetallisierung mit einer weiteren Solarzelle oder mit dem äußeren Stromkreis elektrisch leitend verbindbar ist.

Bei der typischen Verwendung einer Solarzelle zur Erzeugung elektrischer Energie werden mehrere Solarzellen in einem Solarzellenmodul miteinander verschaltet. Hierbei erfolgt die Verschaltung typischerweise in Reihe, d.h. die Rückseitenmetallisierung einer Solarzelle ist mit der Vorderseitenmetallisierung einer benachbarten Solarzelle elektrisch leitend verbunden.

Zur Erhöhung der Effizienz der Solarzelle ist es bekannt, zusätzlich die Rückseite der Solarzelle teilweise durch einen n-dotierten Rückseitenemitter zu bedecken. Denn hierdurch können auch Elektronen, welche im Dotierbereich oder nahe der Rückseite der Solarzelle durch die einfallende Strahlung generiert werden durch den rückseitigen Emitter eingesammelt werden und die Wahrscheinlichkeit, dass die Elektronen mit Löchern rekombinieren und daher nicht zu einer von außen abgreifbaren elektrischen Energie beitragen, verringert sich (siehe z.B. US 5,468,652).

Es sind Solarzellen bekannt, bei denen sowohl der Emitter der Vorderseite, als auch der Emitter der Rückseite eine Metallisierung aufweist, wobei auf der Rückseite eine kammartige Metallisierung des p-Dotierbereiches und eine kammartige Metallisierung des rückseitigen Emitter-Dotierbereiches ineinandergreifen. Die Vorder- und Rückseitenmetallisierung der Emitter sind durch Löcher in der Solarzelle, welche mit einer Metallisierung ausgefüllt sind, elektrisch leitend miteinander verbunden. Bei diesen Solarzellen weist die Rückseite zum einen Kontaktierungsflächen der p-Metallisierung, sowie Kontaktierungsflächen der n-Metallisierung auf, so dass die vollständige Kontaktierung der Solarzelle auf der Rückseite erfolgt.

Das Dokument EP0881694 offenbart eine Solarzelle nach dem Stand der Technik.

Hierdurch ergeben sich jedoch Nachteile bei der Verwendung dieser Solarzelle in Standardmodulen, da aufwendige Methoden zur Kontaktierung und Verschaltung der einzelnen Solarzellen im Modul notwendig sind.

Hiervon ausgehend besteht die Aufgabe der vorliegenden Erfindung darin, eine Solarzelle zu schaffen, welche zum einen die Effizienz gegenüber der herkömmlichen Solarzellenstruktur erhöht und gleichzeitig eine einfache und damit kostengünstige Verschaltung im Modul ermöglicht.

Gelöst ist diese Aufgabe durch eine Solarzelle gemäß Anspruch 1 sowie ein Verfahren gemäß Anspruch 20. Vorteilhafte Ausgestaltungen finden sich in den Ansprüchen 2 bis 18, sowie in einem Solarzellenmodul gemäß Anspruch 19. Vorteilhafte Ausgestaltungen des Verfahrens finden sich in den Ansprüchen 21 bis 26.

Die erfindungsgemäße Solarzelle umfasst somit ein Halbleitersubstrat mit einer Vorder- und einer im Wesentlichen dazu parallelen Rückseite, sowie eine Vorderseitenmetallisierung und eine Rückseitenmetallisierung.

Die Solarzelle weist weiterhin mindestens drei Dotierbereiche mit mindestens zwei unterschiedlichen Leitfähigkeittypen auf:
Zum einen ist an der Vorderseite des Halbleitersubstrates ein erster Dotierbereich eines ersten Leitfähigkeittyps angeordnet, der sich im Wesentlichen über die gesamte Vorderseite des Halbleitersubstrates erstreckt.

An der Rückseite des Halbleitersubstrates ist ein zweiter, sich teilweise über die Rückseite erstreckender Dotierbereich eines zweiten, zum ersten entgegengesetzten Leitfähigkeittyps angeordnet. Weiterhin ist die Rückseite teilweise durch einen dritten Dotierbereich des ersten Leitfähigkeittyps bedeckt.

Der Leitfähigkeittyp eines Dotierbereichs ist durch die p-Dotierung bzw. die hierzu entgegengesetzte n-Dotierung gegeben.

Weiterhin ist die Vorderseitenmetallisierung mit dem ersten Dotierbereich und die Rückseitenmetallisierung mit dem zweiten Dotierbereich elektrisch leitend verbunden, so dass Ladungsträger aus dem ersten Dotierbereich über die Vorderseitenmetallisierung und Ladungsträger aus dem zweiten Dotierbereich über die Rückseitenmetallisierung abgegriffen werden können.

Die Solarzelle umfasst weiterhin eine elektrisch leitende Verbindung, welche die Vorderseitenmetallisierung und/oder den ersten Dotierbereich mit dem dritten Dotierbereich elektrisch leitend verbindet. Ladungsträger können somit aus dem dritten Dotierbereich direkt oder über den ersten Dotierbereich zur Vorderseitenmetallisierung gelangen und von dort abgegriffen werden.

Wesentlich ist, dass sowohl die Vorderseitenmetallisierung mindestens eine Vorderseitenkontaktfläche, als auch die Rückseitenmetallisierung mindestens eine Rückseitenkontaktfläche umfassen, wobei die Kontaktflächen jeweils mindestens 0,5 mm lang und mindestens 0,5 mm breit sind. Die Kontaktflächen sind in etwa parallel zur jeweiligen Seite des Halbleitersubstrats angeordnet.

Hierdurch sind sowohl die Vorderseitenmetallisierung, als auch die Rückseitenmetallisierung mit handelsüblichen Kontaktierungsmethoden kontaktierbar, insbesondere mit handelsüblichen Zellverbindern elektrisch verbindbar.

Die erfindungsgemäße Solarzelle zeichnet sich weiterhin dadurch aus, dass die Kontaktflächen auf einer gemeinsamen, senkrecht zur Rückseite des Substrats stehenden gedachten Ebene liegen. Diese Ebene bildet mit der Rückseite der Solarzelle eine gedachte Rückseiten-Schnittlinie und die erfindungsgemäße Solarzelle ist derart ausgebildet, dass entlang dieser gedachten Rückseiten-Schnittlinie keine elektrische Verbindung zu dem dritten Dotierbereich und keine elektrische Verbindung zu dem ersten Dotierbereich, sowie keine elektrische Verbindung zur Vorderseitenmetallisierung besteht.

Durch diesen Aufbau der erfindungsgemäßen Solarzelle ist es möglich, einen im Wesentlichen linienartigen Zellverbinder entlang der gedachten Rückseiten-Schnittlinie auf der Rückseite der Solarzelle zu führen. Dieser Zellverbinder steht aufgrund der Ausgestaltung der erfindungsgemäßen Solarzelle lediglich mit der Kontaktfläche der Rückseitenmetallisierung in elektrisch leitender Verbindung und ist insbesondere nicht mit dem dritten Dotierbereich, dem ersten Dotierbereich und der Vorderseitenmetallisierung elektrisch leitend verbunden.

Ebenso kann auf einer Vorderseite entlang einer gedachten Vorderseiten-Schnittlinie zwischen der gedachten Ebene und der Vorderseite der Solarzelle ein im Wesentlichen linienartiger Zellverbinder angeordnet werden. Dieser Zellverbinder steht aufgrund der Ausgestaltung der erfindungsgemäßen Solarzelle ausschließlich mit der Vorderseitenmetallisierung über deren Vorderseitenkontaktfläche in elektrisch leitender Verbindung und verläuft parallel zu dem rückseitigen Zellverbinder.

Die erfindungsgemäße Solarzelle kann hierdurch in einem Standardsolarzellenmodul in gleicher Weise verschaltet werden, wie eine herkömmliche Solarzelle, die lediglich einen Emitter an der Vorderseite aufweist.

Dadurch, dass die erfindungsgemäße Solarzelle jedoch einen ersten und zusätzlichen mindestens einen dritten Dotierbereich des ersten Leitfähigkeittyps aufweist, wobei der dritte Dotierbereich an der Rückseite der Solarzelle angeordnet ist, ist die Effizienz der erfindungsgemäßen Solarzelle gegenüber der herkömmlichen Solarzelle erhöht.

Bei der vorangegangen beschriebenen typischen Solarzelle stellt der n-dotierte Emitter an der Vorderseite den ersten Dotierbereich, die p-dotierte Basis (welche somit einen zu dem Emitter entgegengesetzten Leitfähigkeitstyp aufweist) den zweiten Dotierbereich und der n-dotierte Rückseitenemitter den dritten Dotierbereich dar. Ebenso liegt jedoch auch eine Vertauschung der n- und p-Dotierungen im Rahmen der Erfindung.

Untersuchungen der Anmelderin haben ergeben, dass für bestimmte Kontaktierungsverfahren der Kontaktflächen eine größere Fläche vorteilhaft ist. Vorteilhafterweise sind Vorderseitenkontaktfläche und/oder Rückseitenkontaktfläche daher mindestens 0,5 mm lang und mindestens 0,5 mm breit, insbesondere mindestens 1 mm lang und 1 mm breit, höchstinsbesondere mindestens 1,5 mm lang und 1,5 mm breit.

Vorteilhafterweise ist die erfindungsgemäße Solarzelle derart ausgestaltet, dass die Rückseite der Solarzelle entlang der Rückseiten-Schnittlinie mit einem Dotierbereich des zweiten Leitfähigkeittyps bedeckt ist. Hierdurch ist es möglich, die Rückseitenmetallisierung linienartig entlang der Rückseiten-Schnittlinie zu führen, so dass entlang dieser Linie Ladungsträger eingesammelt und zu der auf der Rückseiten-Schnittlinie liegenden Kontaktfläche der Rückseitenmetallisierung geführt werden können.

In einer weiteren vorteilhaften Ausgestaltung ist die Rückseite der Solarzelle entlang der Rückseiten-Schnittlinie und außerhalb der Kontaktfläche mit einer isolierenden Schicht bedeckt.

Ein auf der Rückseite der Solarzelle entlang der Rückseiten-Schnittlinie geführter Zellverbinder wird somit lediglich an der Kontaktfläche in elektrischer Verbindung mit der Rückseitenmetallisierung stehen. Dies weist den Vorteil auf, dass die Rekombination an der Rückseite verringert werden kann.

Wesentlich ist, dass die Solarzelle derart ausgeführt ist, dass ein an der Rückseiten-Schnittlinie auf der Rückseite der Solarzelle geführter Zellverbinder keine elektrische Verbindung mit erstem und drittem Dotierbereich, sowie der Vorderseitenmetallisierung besitzt. Dies kann, wie oben beschrieben, dadurch gewährleistet sein, dass entlang der gesamten Rückseiten-Schnittlinie die Rückseitenmetallisierung entlanggeführt wird oder dass entlang der Rückseiten-Schnittlinie lediglich Rückseitenmetallisierung oder der zweite Dotierbereich angeordnet ist. Ebenso ist es möglich, dass die Solarzelle auf der Rückseite im Bereich der Rückseiten-Schnittlinie zumindest teilweise eine isolierende Schicht aufweist, so dass ein auf die Rückseite der Solarzelle entlang der Rückseiten-Schnittlinie aufgelegter Zellverbinder keine elektrische Verbindung zu unter der isolierenden Schicht angeordneten Dotierbereichen besitzt.

Ferner ist es vorteilhaft, dass sich die Kontaktfläche der Vorderseitenmetallisierung im Wesentlichen über die gesamte Breite der Solarzelle erstreckt, so dass über die gesamte Breite der Solarzelle Ladungsträger aus dem ersten Dotierbereich in die Vorderseitenmetallisierung eintreten können und innerhalb der Vorderseitenmetallisierung zu der Kontaktfläche der Vorderseitenmetallisierung gelangen.

In einer weiteren vorteilhaften Ausgestaltung umfassen die Vorderseitenmetallisierung und/oder die Rückseitenmetallisierung mehrere Kontaktflächen, die auf der gemeinsamen senkrecht zur Vorderseiten stehenden Schnittfläche liegen.

Ein auf der Rückseite entlang der Rückseiten-Schnittlinie oder ein auf der Vorderseite entlang der Vorderseiten-Schnittlinie geführter Zellverbinder steht somit mit mehreren Kontaktierungsflächen elektrisch leitend in Verbindung, so dass Verluste aufgrund des Querleitungswiderstandes in der Metallisierung verringert werden können.

Vorteilhafterweise ist die Kontaktfläche auf der Vorderseite über der Kontaktfläche der Rückseite angeordnet, so dass Vorder- und Rückseitenzellverbinder an der gleichen Position von Vorder- und Rückseite verbunden werden und beim Verbinden somit der jeweils entstehende Druck ausgeglichen wird.

Vorteilhafterweise ist die erfindungsgemäße Solarzelle als p-Siliziumsolarzelle ausgeführt, d.h. das Halbleitersubstrat ist ein p-dotierter Siliziumwafer und der erste und der dritte Dotierbereich stellen n-dotierte Emitter dar.

Hierbei ist es vorteilhaft, wenn der erste Dotierbereich als niedrigohmiger Emitter im Dotierbereich 20 Ohm/sq bis 70 Ohm/sq und der dritte Dotierbereich als hochohmiger Emitter im Dotierbereich 70 Ohm/sq bis 130 Ohm/sq ausgebildet sind, denn Untersuchungen der Erfinder haben ergeben, dass hierdurch zum einen möglichst geringe Verluste aufgrund von Querleitungswiderständen im Emitter und zum anderen niedrige Verluste aufgrund des Kontaktwiderstandes zur Vorderseitenmetallisierung vorliegen und somit die Effizienz der Solarzelle optimiert werden kann.

Insbesondere ist es vorteilhaft, wenn der erste Dotierbereich in etwa als 50 Ohm/sq Emitter und der dritte Dotierbereich als Emitter im Dotierbereich 80 Ohm/sq bis 100 Ohm/sq ausgebildet sind.

In einer weiteren vorteilhaften Ausgestaltung ist die Vorderseitenmetallisierung als Standardkontaktierungsgitter ausgebildet. Dieses umfasst mehrere im Wesentlichen parallel angeordnete linienartige Metallisierungsfinger, welche jeweils eine Breite im Bereich von 30 µm bis 200 µm aufweisen. Diese Metallisierungsfinger sind durch einen senkrecht dazustehenden Busbar miteinander verbunden, welcher als Kontaktierungsfläche ausgebildet ist, d.h. mindestens eine Breite von 1,5 mm aufweist und hinsichtlich seiner Länge in etwa die gesamte Vorderseite der Solarzelle überdeckt. Der Busbar ist leitend mit den Metallisierungsfingern verbunden, so dass Ladungsträger, welche durch die Metallisierungsfinger eingesammelt werden, am Busbar abgegriffen werden können.

In einer weiteren vorteilhaften Ausgestaltung weist die erfindungsgemäße Solarzelle auf ihrer Rückseite mehrere inselartige Dotierbereiche des ersten Leitfähigkeittyps auf, welche durch mindestens einen Dotierbereich des zweiten Leitfähigkeittyps voneinander getrennt sind.

Jeder dieser inselartigen Dotierbereiche ist mit der Vorderseitenmetallisierung leitend verbunden, so dass Ladungsträger der inselartigen Dotierbereiche über die Kontaktierungsfläche der Vorderseitenmetallisierung abgegriffen werden können.

Hierbei ist es insbesondere vorteilhaft, wenn jeder inselartige Dotierbereich des ersten Leitfähigkeittyps eine mit diesem Dotierbereich leitend verbundene Metallisierung aufweist. Diese Metallisierung ist wiederum leitend mit der Vorderseitenmetallisierung verbunden. Die durch die inselartigen Dotierbereiche eingesammelten Ladungsträger können somit in die Metallisierung dieses inselartigen Dotierbereiches eintreten und dann innerhalb der Metallisierung zur Kontaktierungsfläche der Vorderseitenmetallisierung gelangen und dort abgegriffen werden. Hierdurch erniedrigt sich der Serienwiderstand, so dass die Effizienz der Solarzelle erhöht werden kann.

Vorteilhafterweise ist die Metallisierung der inselartigen Dotierbereiche als Metallisierungsfinger ausgeführt, welche eine Breite im Dotierbereich vom 30 bis 200 µm aufweisen.

In einer weiteren vorteilhaften Ausgestaltung ist die Rückseitenmetallisierung als Standardkontaktierungsgitter ausgebildet, welches wie vorhergehend beschrieben, mehrere im Wesentlichen parallel angeordnete linienartige Metallisierungsfinger umfasst, mit einer Breite im Bereich von 30 bis 200 µm. Ferner weist die Rückseitenmetallisierung eine als Busbar ausgebildete Kontaktierungsfläche auf, welche im Wesentlichen senkrecht zu den Metallisierungsfingern steht und diese elektrisch leitend miteinander verbindet. Diese Form der Rückseitenmetallisierung weist den Vorteil auf, dass zwischen den Metallisierungsfingern und dem Busbar an der Rückseite die inselartigen Dotierbereiche des ersten Leitfähigkeittyps angeordnet sein können, so dass die inselartigen Dotierbereiche kammartige in die Rückseitenmetallisierung und damit auch in die Dotierbereiche des zweiten Leitfähigkeittyps an der Rückseite der Solarzelle eingreifen.

Hierdurch kann eine hohe Effizienz der Solarzelle erreicht werden, da die inselartigen Dotierbereiche durch das kammartige Bedecken der Rückseite eine hohe Effizienz beim Einsammeln von Ladungsträgern erzielen.

Die Solarzelle weist Ausnehmungen auf, welche im wesentlichen senkrecht zu der Vorderseite der Solarzelle stehen und sowohl den ersten als auch den dritten Dotierbereich durchdringen, wobei der erste und der dritte Dotierbereich durch die Ausnehmung elektrisch leitend verbunden sind. Diese Ausnehmungen können beispielsweise als Löcher, d.h. im Wesentlichen zylindrische oder quaderförmige Ausnehmungen ausgebildet sein.

Die elektrische Verbindung zwischen erstem und drittem Dotierbereich kann vorteilhafterweise dadurch gewährleistet sein, dass die Ausnehmung an den Wänden zumindest teilweise einen Dotierbereich des ersten Leitfähigkeittyps aufweist, welcher derart angeordnet ist dass er den ersten und den dritten Dotierbereich elektrisch leitend verbindet.

In dieser vorteilhaften Ausführungsform können somit Ladungsträger von einem dritten Dotierbereich an der Rückseite über die Wände der Ausnehmung zu dem ersten Dotierbereich an der Vorderseite gelangen und dort in die Vorderseitenmetallisierung eintreten.

Ebenso ist es auch vorteilhaft, dass die Ausnehmungen zumindest teilweise eine Metallisierung aufweisen, welche den ersten und den dritten Dotierbereich elektrisch leitend verbinden. In diesem Fall können Ladungsträger aus dem dritten Dotierbereich in die Metallisierung in der Ausnehmung eintreten und über diese Metallisierung zur Vorderseitenmetallisierung gelangen.

Herkömmliche Solarzellen weisen typischerweise eine ganzflächige Rückseitenmetallisierung auf. Diese stellt neben ihrer Funktion als Rückseitenkontaktierung auch einen optischen Spiegel dar, welcher von der Vorderseite eindringende elektromagnetische Strahlung reflektiert, so dass die in der Solarzelle absorbierte Strahlung erhöht werden kann.

Bei der erfindungsgemäßen Solarzelle findet keine ganzflächige Bedeckung der Rückseite durch die Rückseitenmetallisierung statt. Vorteilhafterweise weist die erfindungsgemäße Solarzelle daher einen optischen Spiegel auf, welcher die Rückseite der Solarzelle bedeckt, so dass über die Vorderseite in die Solarzelle einfallende Strahlung reflektiert wird und dadurch die Absorption in der Solarzelle erhöht wird. Vorteilhafterweise ist der Spiegel als Aluminiumschicht ausgebildet.

Wie vorhergehend erwähnt, weist die erfindungsgemäße Solarzelle den Vorteil auf, dass sie nach Art einer Standardsolarzelle in einem Modul verschaltet werden kann. In einer vorzugsweisen Ausführungsform ist ein Solarzellenmodul mit erfindungsgemäßen Solarzellen derart aufgebaut, dass mindestens zwei Solarzellen nebeneinanderliegend angeordnet sind, wobei mindestens ein Zellverbinder die Rückseitenmetallisierung der ersten Solarzelle mit der Vorderseitenmetallisierung der zweiten Solarzelle verbindet.

Der Solarzellenverbinder ist dabei derart ausgeführt, dass er von oben betrachtet im Wesentlichen gradlinig verläuft.

Vorteilhafterweise weist das Halbleitersubstrat eine flache Form auf, wie beispielsweise ein Siliziumwafer. Vorder- und Rückseite einer Solarzelle sind typischerweise im Wesentlichen plan, wobei geringfügige Strukturierungen zur Texturierung, d.h. Verbesserung der optischen Eigenschaften der Vorder- oder Rückseite der Solarzelle oder eine Strukturierung zur Begrenzung von Dotierbereichen vorteilhaft sein können. Typischerweise liegt die Dicke des Halbleitersubstrates im Bereich 50 µm bis 300 µm, wobei die Texturierungen und Strukturierungen an Vorder- oder Rückseite der Solarzelle typischerweise Höhenunterschiede von weniger als 15 µm aufweisen.

Vorteilhafterweise ist das Halbleitersubstrat im Wesentlichen quaderförmig und die gedachte Ebene ist parallel zu einer Stirnseite des Halbleitersubstrates.

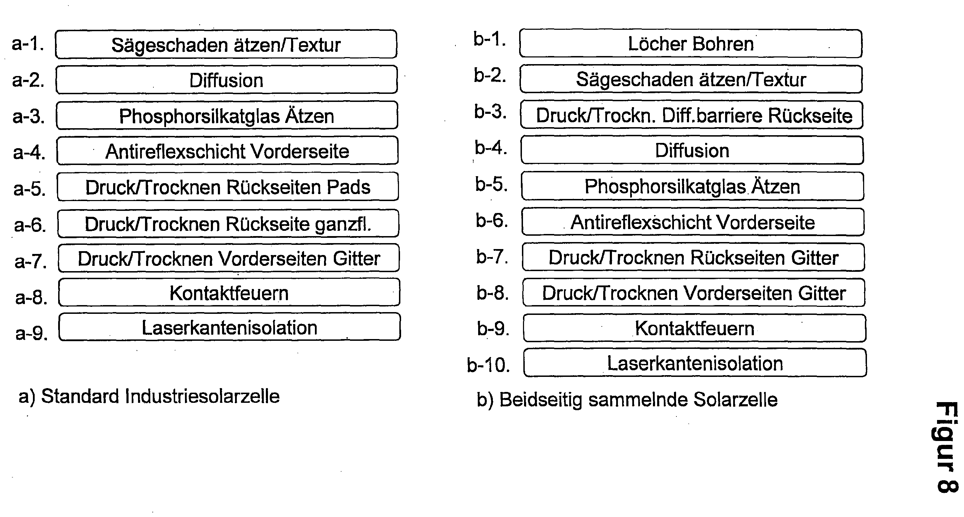

Die vorhergehend beschriebene erfindungsgemäße Solarzelle weist weiterhin den Vorteil auf, dass sie im Wesentlichen mit einem Standard-Herstellungsverfahren herstellbar ist. Die zugrunde liegende Aufgabe ist daher ebenso durch ein Verfahren gemäß Anspruch 20 gelöst, welche folgende Verfahrensschritte umfasst (die Nummerierungen beziehen sich hierbei bereits auf das in Figur 8 dargestellte Ausführungsbeispiel):
Bei dem erfindungsgemäßen Verfahren wird aus einem Halbleiterwafer mit einer Vorder- und einer im Wesentlichen dazu parallelen Rückseite in einem Schritt b-2 der Sägeschaden entfernt.

Anschließend wird in einem Schritt b-4 ein erster Dotierbereich eines ersten Leitfähigkeittyps diffundiert. Der erste Dotierbereich erstreckt sich im Wesentlichen über die gesamte Vorderseite des Halbleiterwafers und damit der späteren Solarzelle. Weiterhin wird mindestens ein dritter Dotierbereich des ersten Leitfähigkeitstyps diffundiert, wobei sich der dritte Dotierbereich teilweise über die Rückseite der Solarzelle erstreckt.

In einem Schritt b-7 wird eine Rückseitenmetallisierung aufgebracht, welche die Rückseite teilweise bedeckt und entsprechend wird in einem Schritt b-8 eine Vorderseitenmetallisierung aufgebracht, welche die Vorderseite teilweise bedeckt.

Wesentlich ist, dass in dem zuvor beschriebenen Schritt b-7 die Rückseitenmetallisierung die Rückseite nur teilweise bedeckt und dass bei Aufbringen der Vorderseite eine etwa parallel zur Vorderseite liegende Vorderseitenkontaktfläche ausgebildet wird und bei der Rückseite eine etwa parallel zur Rückseite liegende Rückseitenkontaktfläche ausgebildet wird. Vorder- und Rückseitenkontaktfläche sind jeweils mindestens 0,5 mm lang und 0,5 mm breit und die Vorder- und Rückseitenkontaktfläche werden derart angeordnet, dass sie von einer gemeinsamen, senkrecht zur Rückseite stehenden gedachten Ebene durchdrungen werden.

Die Solarzelle wird ferner derart ausgebildet, dass an der Rückseite der Solarzelle entlang einer gedachten Rückseiten-Schnittlinie zwischen der Rückseite der Solarzelle und der gedachten Ebene keine elektrische Verbindung zu dem dritten Dotierbereich und keine elektrische Verbindung zu dem ersten Dotierbereich besteht.

Hierdurch ist gewährleistet, dass ein entlang der Rückseiten-Schnittlinie auf der Rückseite der Solarzelle geführter elektrisch leitender Zellverbinder lediglich mit der Rückseitenmetallisierung und/oder dem zweiten Dotierbereich elektrisch leitend verbunden ist.

Vorteilhafterweise wird bei dem erfindungsgemäßen Verfahren an der Rückseite der Solarzelle entlang der Rückseiten-Schnittlinie ein Dotierbereich des zweiten Leitfähigkeittyps ausgebildet.

In einer weiteren vorteilhaften Ausbildung des erfindungsgemäßen Verfahrens wird an der Rückseite der Solarzelle entlang der Rückseitenschnittlinie und außerhalb der Rückseitenkontaktfläche die Rückseite mit einer isolierenden Schicht bedeckt.

Zur Verbindung des ersten und dritten Dotierbereichs ist es vorteilhaft, dass in einem Schritt b-1 Löcher in der Solarzelle erzeugt werden, welche im Wesentlichen senkrecht zur Vorderseite der Solarzelle stehen. Insbesondere ist es vorteilhaft, diese Löcher mittels eines Lasers zu erzeugen, da hierdurch eine ortsgenaue und schnelle Erzeugung der Löcher möglich ist.

In einer weiteren vorteilhaften Ausgestaltung des Verfahrens wird in einem Schritt b-4 zusätzlich an den Lochwänden ein Dotierbereich des ersten Leitfähigkeitstyps erzeugt und der dritte Dotierbereich wird im Bereich der Löcher angeordnet, so dass der erste und dritte Dotierbereich über den Dotierbereich an den Lochwänden elektrisch leitend miteinander verbunden sind.

Weitere vorteilhafte Ausgestaltungen werden im Folgenden anhand der in den Figuren dargestellten Ausführungsbeispiele näher erläutert. Dabei zeigen:
- Figur 1: die Vorderseite einer erfindungsgemäßen Solarzelle in schematischer Darstellung,
- Figur 2: die Rückseite der erfindungsgemäßen Solarzelle in schematischer Darstellung,
- Figur 3: eine Schnittdarstellung entlang der in Figur 1 und Figur 2 mit I bezeichneten Linie, wobei die Schnittebene senkrecht zur Zeichenebene in Figur 1 und in Figur 2 steht,
- Figur 5: mehrere, mit Zellverbindern in Reihe geschaltete erfindungsgemäße Solarzellen in Draufsicht von oben,
- Figur 6: mehrere, mit Zellverbindern in Reihe geschaltete erfindungsgemäße Solarzellen in Draufsicht von unten und
- Figur 7: eine Schnittdarstellung durch die in Figur 5 und in Figur 6 dargestellten mit Zellverbindern verbundenen Solarzellen, wobei die Schnittebene senkrecht zur Zeichenebene in Figur 5 und in Figur 6 steht und in etwa mittig durch die von den Zellverbindern gebildete Linie verläuft und
- Figur 8: eine Gegenüberstellung eines Herstellungsverfahrens für eine Solarzelle nach dem Stand der Technik und eine erfindungsgemäße Solarzelle.

Das Halbleitersubstrat der in den Figuren dargestellten erfindungsgemäßen Solarzelle ist ein quaderförmiger Siliziumwafer, dessen Länge und Breite in etwa 12 cm beträgt und der eine Dicke von etwa 250 µm besitzt.

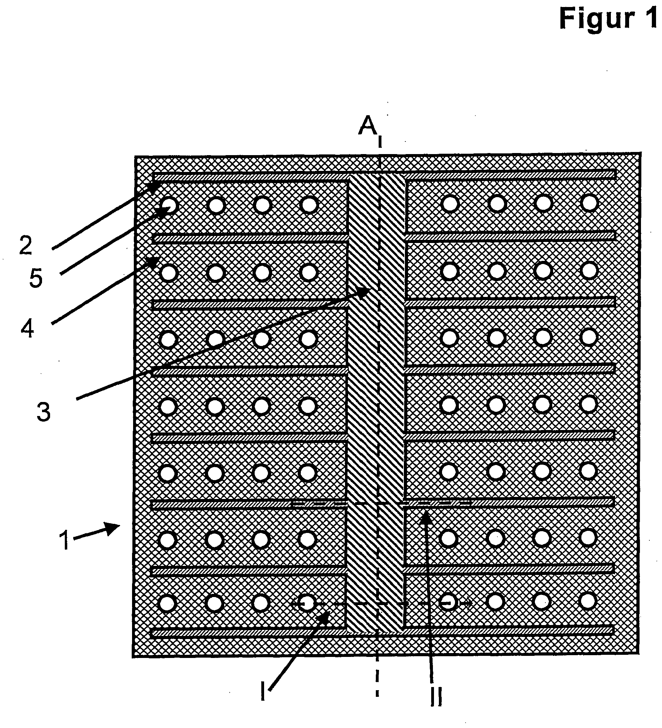

Wie in Figur 1 ersichtlich, ist auf der Vorderseite des Siliziumwafers 1 eine doppelkammartige Vorderseitenmetallisierung 2 aufgebracht. Die Vorderseitenmetallisierung 2 umfasst einen mittig angeordneten Vorderseitenbusbar 3, von dem ausgehend sich demgegenüber schmalere Metallisierungsstreifen, die sogenannten Finger über die Oberfläche der Solarzelle erstrecken.

Die Vorderseite des Siliziumwafers 1 ist vollständig von einem in Figur 1 schräg kariert dargestellten n-dotierten Bereich bedeckt, dem Vorderseitenemitter 4. Der Vorderseitenemitter 4 stellt somit den ersten Dotierbereich dar.

Weiterhin ist der Siliziumwafer 1 durch mehrere im Wesentlichen zylindrische Löcher 5 durchdrungen.

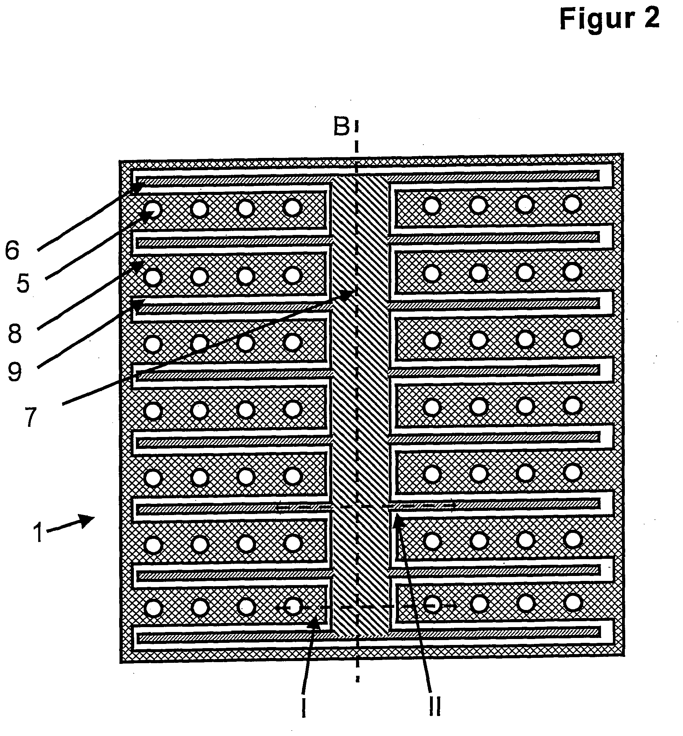

Wie in der in Figur 2 dargestellten Rückseitenansicht der erfindungsgemäßen Solarzelle ersichtlich, ist auf der Rückseite des Siliziumwafers 1 die Rückseitenmetallisierung 6 angeordnet, welche ebenfalls doppelkammartig ausgeführt ist und einen mittigen Rückseitenbusbar 7 umfasst, von dem sich die Finger der Rückseitenmetallisierung über die Rückseite des Siliziumwafers 1 erstrecken.

Auch die Rückseite weist einen n-dotierten Bereich auf, den in Figur 2 schräg kariert dargestellten Rückseitenemitter 8, welcher die Rückseite teilweise bedeckt, insbesondere im Bereich der Löcher 5. Der Rückseitenemitter 8 stellt somit den dritten Dotierbereich dar.

Der Siliziumwafer 1 besitzt eine p-Grunddotierung, d.h. er ist außerhalb der Emitterbereiche p-dotiert. Dieser p-dotierte Bereich stellt somit die Basis der erfindungsgemäßen Solarzelle dar. Wie in Figur 2 ersichtlich, ist die Rückseite des Siliziumwafers 1 im Bereich der Rückseitenmetallisierung 6 nicht durch den Rückseitenemitter 8 bedeckt, so dass die Rückseitenmetallisierung 6 unmittelbar auf der Basis 9 aufliegt und elektrisch leitend mit dieser verbunden ist. Die Basis 9 stellt somit den zweiten Dotierbereich dar.

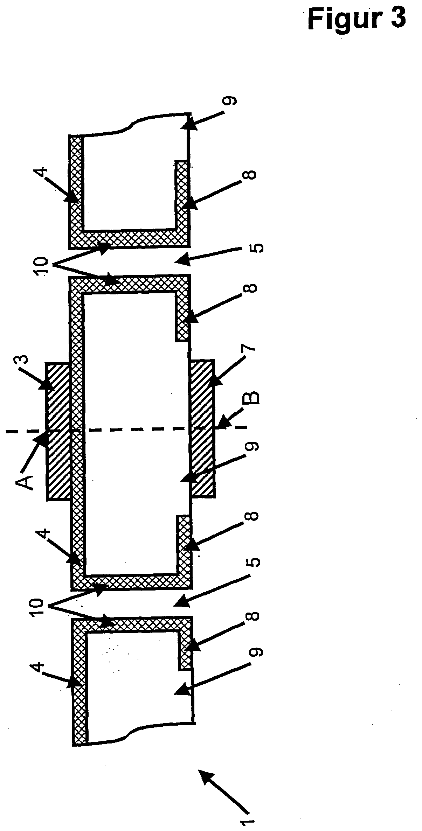

Figur 3 stellt einen Querschnitt senkrecht zur Zeichenebene in Figur 1 und Figur 2 an der mit I gekennzeichneten, gestrichelt dargestellten Linie dar.

Bei dem von den Löchern 5 durchdrungenen Siliziumwafer 1 ist an der Vorderseite der Vorderseitenemitter 4 angeordnet, welcher die gesamte Vorderseite bedeckt. Die Rückseite des Siliziumwafers 1 ist teilweise durch den Rückseitenemitter 8 und teilweise durch die Basis 9 bedeckt. An den Wänden der Löcher 5 ist ein Verbindungsemitter 10 angeordnet, so dass der Rückseitenemitter 8 über den Verbindungsemitter 10 elektrisch leitend mit dem Vorderseitenemitter 4 verbunden ist.

Ebenso wäre es möglich, alternativ oder zusätzlich eine Verbindungsmetallisierung in den Löchern 5 vorzusehen, welche den Rückseitenemitter 8 elektrisch leitend mit dem Vorderseitenemitter 4 und/oder der Vorderseitenmetallisierung 2 verbindet.

Wesentlich ist nun, dass die Vorderseitenmetallisierung und die Rückseitenmetallisierung jeweils eine Kontaktfläche umfassen, wobei die Kontaktfläche mindestens 0,5 mm lang und mindestens 0,5 mm breit ist.

Diese Kontaktflächen sind bei dem in den Figuren dargestellten Ausführungsbeispiel durch den Vorderseitenbusbar 3 und den Rückseitenbusbar 7 realisiert. Vorder- und Rückseitenbusbar besitzen eine Breite von 2 mm und eine Länge von etwa 11 cm. Sie weisen somit eine ausreichende Fläche auf, um mit einem Zellverbinder verbunden zu werden.

Vorder- und Rückseitenbusbar werden von einer gemeinsamen gedachten Ebene durchdrungen, welche senkrecht zur Rückseiten des Siliziumwafers 1 steht.

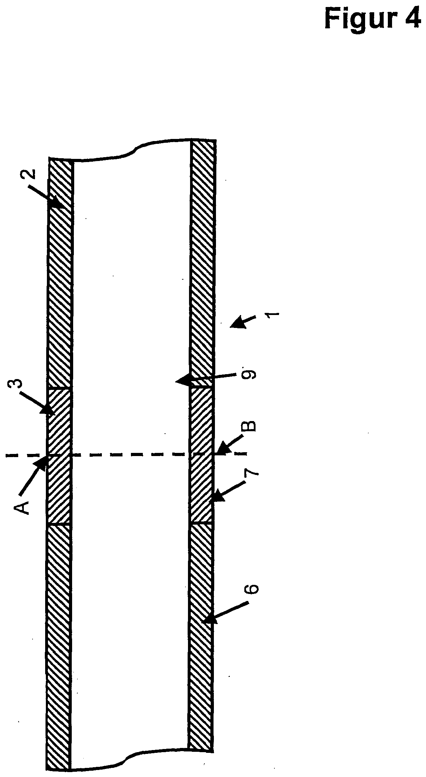

Diese gedachte Ebene ist in den Figuren 1 bis 4 jeweils durch eine mittige gestrichelte Linie dargestellt, wobei die gedachte Ebene in den Figuren 1 bis 4 jeweils senkrecht zur Zeichenebene steht.

An der Vorderseite der Solarzelle stellt der Vorderseitenbusbar 3 im Bereich der gedachten Ebene die höchste Erhebung dar, so dass die Schnittlinie der Oberseite des Vorderseitenbusbars 3 mit der gedachten Ebene die Vorderseiten-Schnittlinie darstellt. Diese Schnittlinie ist in Figur 1 gestrichelt dargestellt und mit A bezeichnet, wobei am äußersten oberen und unteren Rand der Solarzelle keine Vorderseitenmetallisierung vorhanden ist und die Vorderseiten-Schnittlinie A in diesem Bereich somit die Schnittlinie zwischen Vorderseite des Siliziumwafers 1 und der gedachten Ebene ist.

Analog stellt an der Rückseite der Solarzelle der Rückseitenbusbar 7 im Bereich der gedachten Ebene die höchste Erhebung dar, so dass die Schnittlinie zwischen Unterseite des Rückseitenbusbars 7 und der gedachten Ebene die Rückseiten-Schnittlinie darstellt, welche in Figur 2 durch die mit B gekennzeichnete gestrichelte Linie dargestellt ist. Auch auf der Rückseite befindet sich im äußersten oberen und unteren Bereich keine Rückseitenmetallisierung, so dass in diesem Bereich die Rückseiten-Schnittlinie entlang des Rückseitenemitters 8, d.h. auf der Rückseite des Siliziumwafers 1 verläuft.

Entsprechend ist die Position von Vorderseiten-Schnittlinie A und Rückseiten-Schnittlinie B in Figur 3 gekennzeichnet, wobei die Schnittlinien in diesen Figuren jeweils senkrecht zur Zeichenebene stehen.

Auf der Rückseite des Siliziumwafers 1 ist in den Bereichen, die von dem Rückseitenemitter 8 bedeckt sind, der Siliziumwafer 1 von einer (nicht dargestellten) Siliziumdioxydschicht bedeckt, welche eine Dicke von etwa 10 nm aufweist. Diese "native" Siliziumdioxydschicht entsteht durch Oxidation mit dem Sauerstoff der Umgebung und muss daher nicht durch einen gesonderten Prozessschritt hergestellt werden. Die Siliziumdioxydschicht ist isolierend, so dass entlang der Rückseiten-Schnittlinie B in den Bereichen, die nicht durch die Rückseitenmetallisierung bedeckt sind, eine Isolierung zu dem Rückseitenemitter 8 durch die Siliziumdioxydschicht besteht. Ebenso ist es denkbar, in einem gesonderten Prozessschritt eine isolierende Schicht in diesen Bereichen aufzubringen.

Entlang der gesamten Rückseiten-Schnittlinie B besteht somit keine elektrische Verbindung zu dem Rückseitenemitter 8, dem Vorderseitenemitter 4, dem Verbindungsemitter 10 oder der Vorderseitenmetallisierung 2.

Durch diese Ausgestaltung kann die in diesem Ausführungsbeispiel dargestellte erfindungsgemäße Solarzelle mit einem Standard-Verschaltungsverfahren in einem Modul verschaltet werden:
Wie eingangs bereits erläutert, werden Solarzellen im Modul typischer Weise durch Zellverbinder in Reihe geschaltet, indem der elektrisch leitende Zellverbinder die Vorderseitenmetallisierung einer Solarzelle mit der Rückseitenmetallisierung einer benachbarten Solarzelle verbindet.

Wesentlich dabei ist, dass die Zellverbinder im Wesentlichen gradlinig sind, so dass bei reihenartig benachbart angeordneten Solarzellen die Vorderseitenkontaktfläche und die Rückseitenkontaktflächen der Solarzellen derart angeordnet sein müssen, dass sie von einer gemeinsamen, senkrecht zur Rückseite stehenden gedachten Ebene durchdrungen werden, damit der Zellverbinder auf einer Zelle beispielsweise entlang der Vorderseiten-Schnittlinie geführt werden kann und auf der benachbarten Zelle entlang der Rückseiten-Schnittlinie.

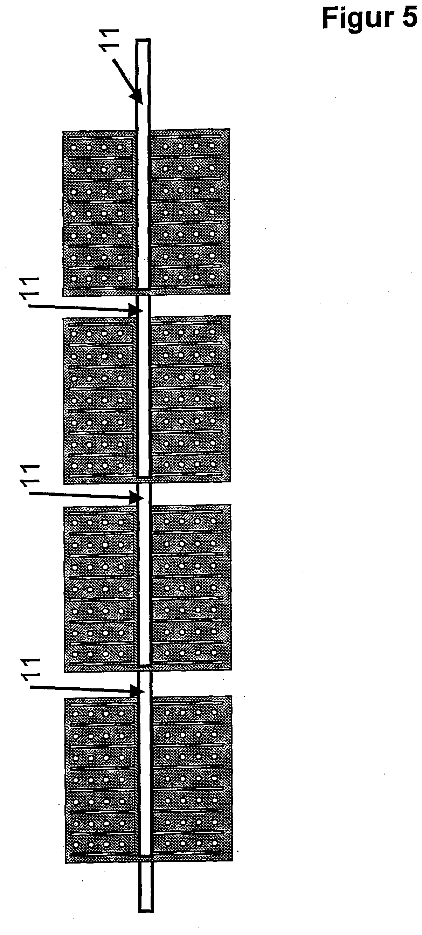

Dieses Verschaltungsprinzip ist in den Figuren 5 bis 7 dargestellt.

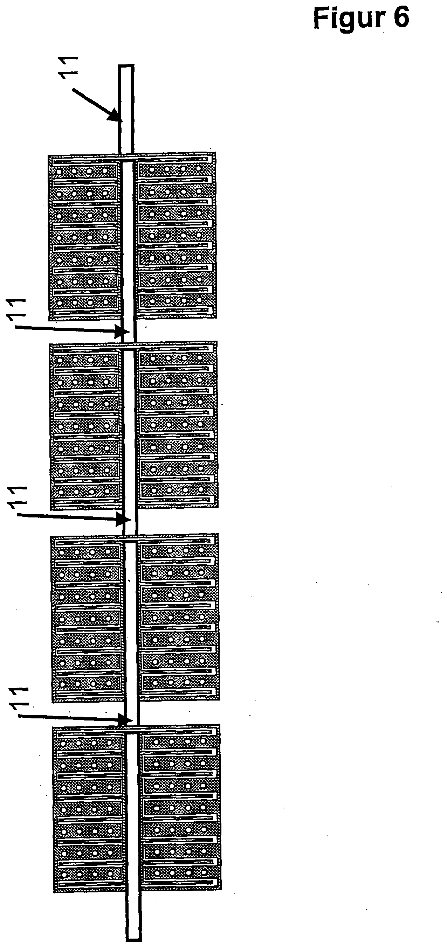

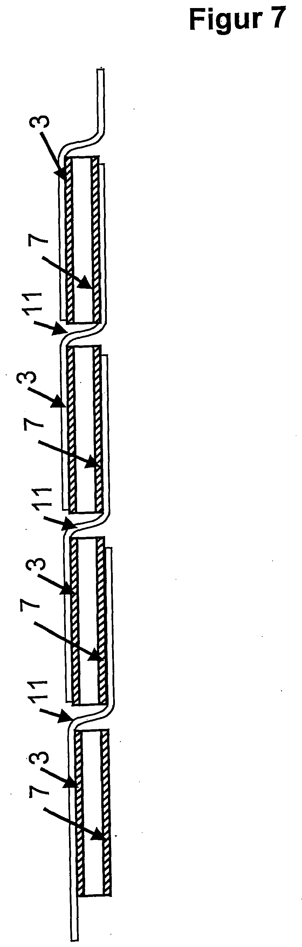

In Figur 5 sind vier erfindungsgemäße Solarzellen reihenartig nebeneinander angeordnet, wobei jede Solarzelle mit der benachbarten Solarzelle über einen Zellverbinder 11 elektrisch leitend verbunden ist. Wie in der Schnittzeichnung in Figur 7 dargestellt, verbindet der Zellverbinder 11 den Rückseitenbusbar 7 einer Solarzelle mit dem Vorderseitenbusbar 3 einer hierzu benachbarten Solarzelle. Durch die Anordnung von Vorderseiten- und Rückseitenbusbar bei der erfindungsgemäßen Solarzelle kann der Zellverbinder hierbei linienartig geführt werden, d.h. in Draufsicht von oben wie in Figur 5 dargestellt, verläuft der Zellverbinder 11 linienartig von der Vorderseite einer Solarzelle zur Rückseite der nächsten Solarzelle. Ebenso ist der linienartige Verlauf des Zellverbinders 11 bei der Ansicht von unten der in Reihe geschalteten erfindungsgemäßen Solarzellen in Figur 6 ersichtlich.

Diese Art der Verschaltung mittels eines bei Draufsicht von oben linienartig geführten Zellverbinders stellt ein Standardverfahren bei der Modulverschaltung dar. Insbesondere ist es vorteilhaft, wenn der Zellverbinder im Wesentlichen die gesamte Breite der Solarzelle überdeckt, so dass ein möglichst geringer Kontaktwiderstand zwischen Zellverbinder 11 und Vorderseitenbusbar 3 bzw. Rückseitenbusbar 7 aufgrund der großen Kontaktfläche ermöglicht wird und zum anderen der Querleitungswiderstand von Vorder- und Rückseitenbusbar zusätzlich durch den parallel laufenden Zellverbinder 11 verringert wird, so dass insgesamt Leistungsverluste aufgrund von ohmschen Widerständen minimiert sind.

Die erfindungsgemäße Solarzelle vereint somit die Vorzüge, dass sie mit einem standardmäßigen Verfahren im Modul verschaltet werden kann und darüber hinaus sowohl über den ersten Dotierbereich (den Vorderseitenemitter 4 des Ausführungsbeispiels) Ladungsträger an der Vorderseite eingesammelt werden, sowie über den dritten Dotierbereich (der Rückseitenemitter 8 des Ausführungsbeispiels) an der Rückseite Ladungsträger eingesammelt werden.

Ein weiterer Vorteil der erfindungemäßen Solarzelle ist, dass sie mit den Standardprozessschritten der Herstellung einer industrieüblichen Solarzelle hergestellt werden kann, wobei nur geringe Modifizierungen notwendig sind.

In Figur 8 ist in der linken Spalte (a) der Ablauf bei der Herstellung einer herkömmlichen Industriesolarzelle dargestellt. Solch eine Industriesolarzelle besitzt auf der Vorderseite einen Emitter, das restliche Halbleitersubstrat stellt die Basis dar. Der Emitter ist durch eine auf der Vorderseite aufgebrachten Vorderseitenmetallisierung und die Basis durch eine auf die Rückseite aufgebrachten Rückseitenmetallisierung kontaktiert.

Bei der Herstellung wird zunächst in einem Schritt a-1 der Sägeschaden des Halbleiters entfernt und es wird eine Textur auf der Vorderseite aufgebracht, um die Lichtausbeute der Solarzelle zu erhöhen. Der Halbleiterwafer ist dabei typischerweise homogen mit einer p-Dotierung versehen.

In einem Diffusionsschritt a-2 wird der Emitter an der mit einer Textur versehenen Vorderseite des Halbleiterwafers eindiffundiert.

Bei diesen Prozessschritten entsteht Phosphorsilikatglas, welches in einem Schritt a-3 abgeätzt wird.

Um die Lichtausbeute der Solarzelle weiter zu erhöhen, wird in einem Schritt a-4 eine Antireflexschicht auf die Vorderseite aufgebracht. Dies kann beispielsweise eine einlagige Siliziumdioxidschicht oder eine Siliziumnitridschicht sein, ebenso sind jedoch auch mehrlagige Antireflexschichten bekannt.

In den Schritten a-5 bis a-7 werden mittels Druckverfahren die Vorder- und die Rückseitenmetallisierung aufgebracht.

Bei einem Standardverfahren werden hierbei zunächst in einem Schritt a-5 die sogenannten "Pads", d.h. die Kontaktierungsflächen auf die Rückseite gedruckt und nach Trocknen dieser Kontaktierungsflächen wird in einem Schritt a-6 die Rückseite ganzflächig metallisiert.

In einem Schritt a-7 wird hierbei die Vorderseitenmetallisierung in Form eines wie vorhergehend beschriebenen kammartigen Metallisierungsgitter aufgedruckt. Die Reihenfolge der Druckschritte kann hierbei auch vertauscht werden.

Durch Wärmeeinwirkung wird erreicht, dass die aufgedruckten Metallisierungen einen elektrischen Kontakt zu den darunterliegenden Dotierbereichen bilden. Dies wird auch als "Kontaktfeuern" benannt und ist in Figur 8 als Schritt a-8 dargestellt.

Um elektrische Kurzschlüsse und Schädigungen, welche an den Kanten des Halbleiterwafers typischerweise auftreten zu vermeiden, wird in einem Schritt a-9 eine Laserkantenisolation durchgeführt, d.h. ein dünner, umlaufender Randbereich des Halbleiterwafers wird mittels Lasereinwirkung elektrisch von der restlichen Solarzelle getrennt, sodass auch in diesem Randbereich eventuell vorhandene Kurzschlüsse oder andere Schädigungen der Halbleiterstruktur keinen oder nur einen vernachlässigbar geringen Einfluss auf die elektrische Eigenschaft der Solarzelle haben. Ebenso ist es möglich, die Laserkantenisolation direkt nach der Diffusion, insbesondere direkt nach Schritt a-2 (bzw. b-4 bei dem erfindungsgemäßen Verfahren) durchzuführen. Vorteilhafterweise wird die Laserkantenisolation von der Vorderseite aus durchgeführt.

Wie in der mit (b) gekennzeichneten rechten Spalte in Figur 8 ersichtlich, weist das in Figur 8 beispielhaft dargestellte Verfahren zur Herstellung einer erfindungsgemäßen Solarzelle lediglich einen Prozessschritt mehr auf, als das Verfahren zur Herstellung der bekannten Solarzelle:
In einem zusätzlichen Schritt b-1 werden zu Beginn vor Entfernung des Sägeschadens die Ausnehmungen in dem Halbleiterwafer erzeugt, welche eine elektrische Verbindung des ersten und dritten Dotierbereichs ermöglichen. Diese Löcher in dem Halbleiterwafer, welche in etwa senkrecht zur Vorder- und Rückseite den Halbleiterwafer durchdringen, werden vorzugsweise mittels eines Lasers hergestellt, d. h. durch Wärmeeinwirkung mittels eines Lasers wird das Halbleitermaterial an einigen Stellen verdampft, sodass die Solarzelle Löcher erhält, wie beispielsweise in Figur 1 und 2 dargestellt.

Einen weiteren zusätzlichen Schritt stellt der mit b-3 gekennzeichnete Verfahrensschritt dar. Hierbei wird auf der Rückseite eine sogenannte Diffusionsbarriere aufgedruckt. Diese dient dazu, die auf der Rückseite kammartig ineinander verschränkten Dotierbereiche (siehe Figur 2) elektrisch voneinander zu trennen. Die Diffusionsbarriere verläuft somit in etwa entlang der in Figur 2 ersichtlichen Grenze zwischen zweitem und drittem Dotierbereich.

Vorteilhafterweise wird zusätzlich auf der Rückseite im Bereich der Kanten eine Diffusionsbarriere aufgebracht, insbesondere gleichzeitig mit der Diffusionsbarriere in Verfahrensschritt b-3, so dass kein zusätzlicher Verfahrensschritt notwendig ist. Durch diese Diffusionsbarriere ist die Kantenisolation nicht mehr notwendig, so dass Verfahrensschritt b-10 entfallen kann.

Da auf Vorder- und Rückseite der Solarzellen lediglich eine Metallisierung nach Art eines kammartigen Gitters aufgebracht wird, können die bei der Standardindustriesolarzelle als Verfahrensschritte a 5 bis a 7 dargestellten Verfahrensschritte durch lediglich zwei Verfahrensschritte b 7 bis b 8 realisiert werden, d.h. einerseits Drucken und Trocknen des Rückseitengitters und andererseits Drucken und Trocknen des Vorderseitengitters. Ebenso liegt es im Rahmen der Erfindung, Vorderseiten und/oder Rückseitengitter in mehrstufigen Druckschritten aufzubringen.

Alternativ zu dem zuvor beschriebenen Aufbringen einer Diffusionsbariere in dem Verfahrensschritt b-3 ist es auch möglich, den Schritt b-3 auszulassen und stattdessen nach der Diffusion (Verfahrensschritt b-4) eine elektrische Trennung zwischen zweitem und drittem Dotierbereich an der Rückseite der Solarzelle mittels eines Lasers durchzuführen. Hierzu wird ein Laserstrahl an der Rückseite der Solarzelle entlang des Randes des dritten Dotierbereiches entlanggeführt, sodass durch die Wärmeeinwirkung eine elektrische Isolierung zwischen zweitem und drittem Dotierbereich erzielt wird. Vorteilhafterweise wird dies in Schritt b-10 unter gleichzeitiger Kantenisolation durchgeführt.

Die Bezeichnung "elektrisch leitende Verbindung" bei der vorangegangenen Beschreibung schließt Ströme aus, die unter gewissen Bedingungen über den pn-Übergang der Solarzelle fließen können, bzw. durch Rekombinationseffekte am pn-Übergang entstehen können.

Im Sinne dieser Beschreibung ist die Vorderseitenmetallisierung mit dem ersten und dritten Dotierbereich elektrisch leitend verbunden, nicht jedoch mit dem zweiten Dotierbereich oder der Rückseitenmetallisierung, da hierzu die Majoritätsladungsträger im ersten und dritten Dotierbereich den pn-Übergang überwinden müssten. Ebenso ist der zweite Dotierbereich nicht mit dem ersten und zweiten Dotierbereich oder der Vorderseitenmetallisierung elektrisch leitend verbunden, da hierzu die Majoritätsladungsträger im zweiten Dotierbereich den pn-Übergang überwinden müssten.

## Patentansprüche

1. Solarzelle, umfassend
ein Halbleitersubstrat mit einer Vorder- und einer im Wesentlichen dazu parallelen Rückseite,
eine Vorderseitenmetallisierung (2) und eine Rückseitenmetallisierung (6) und
drei Dotierbereiche mit zwei unterschiedlichen Leitfähigkeittypen:
- an der Vorderseite des Halbleitersubstrates ist ein erster, sich im wesentlichen über die gesamte Vorderseite erstreckender Dotierbereich eines ersten Leitfähigkeittyps angeordnet,
- an der Rückseite des Halbleitersubstrates ist ein zweiter, sich teilweise über die Rückseite erstreckender Dotierbereich eines zweiten, zu dem ersten Leitfähigkeittyps entgegengesetzten Leitfähigkeittyps angeordnet und
- an der Rückseite ist ein dritter, sich teilweise über die Rückseite erstreckender Dotierbereich des ersten Leitfähigkeittyps angeordnet,
wobei die Vorderseitenmetallisierung (2) mit dem ersten Dotierbereich und die Rückseitenmetallisierung (6) mit dem zweiten Dotierbereich elektrisch leitend verbunden ist und
die Solarzelle eine elektrisch leitende Verbindung aufweist, welche den dritten Dotierbereich mit der Vorderseitenmetallisierung (2) und/oder dem ersten Dotierbereich elektrisch leitend verbindet,
wobei die Solarzelle Ausnehmungen aufweist, welche im Wesentlichen senkrecht zu der Vorderseite der Solarzelle stehen und sowohl den ersten, als auch den dritten Bereich durchdringen, wobei der erste und der dritte Bereich durch die Ausnehmung elektrisch leitend verbunden sind,
**dadurch gekennzeichnet,**
**dass** die Vorderseitenmetallisierung (2) mindestens eine in etwa parallel zur Vorderseite liegende Vorderseitenkontaktfläche und die Rückseitenmetallisierung (6) mindestens eine in etwa parallel zur Rückseite liegende Rückseitenkontaktfläche umfassen und die Vorderseitenkontaktfläche und die Rückseitenkontaktfläche jeweils mindestens 0,5 mm lang und mindestens 0,5 mm breit sind,
wobei Vorder- und Rückseitenkontaktfläche derart angeordnet sind, dass sie von einer gemeinsamen, senkrecht zur Rückseite stehenden gedachten Ebene durchdrungen werden, und die Solarzelle derart ausgebildet ist, dass an der Rückseite der Solarzelle entlang einer gedachten Rückseiten-Schnittlinie zwischen der Rückseite der Solarzelle und der gedachten Ebene, keine elektrische Verbindung zu dem dritten Dotierbereich und keine elektrische Verbindung zu dem ersten Dotierbereich besteht, so dass an der Rückseite der Solarzelle entlang der Rückseiten-Schnittlinie kein elektrischer Kontakt zu dem ersten und zu dem dritten Dotierbereich besteht,
derart, dass ein entlang der Rückseiten-Schnittlinie auf die Rückseite der Solarzelle geführter elektrisch leitender Zellverbinder (11) lediglich mit der Rückseitenmetallisierung (6) und/oder dem zweiten Dotierbereich elektrisch leitend verbunden ist.

2. Solarzelle nach Anspruch 1,
**dadurch gekennzeichnet,**
**dass** die Rückseite der Solarzelle entlang der Rückseiten-Schnittlinie mit einem Bereich des zweiten Leitfähigkeittyps bedeckt ist.

3. Solarzelle nach einem der vorangegangenen Ansprüche,
**dadurch gekennzeichnet,**
**dass** die Rückseite der Solarzelle entlang der Rückseiten-Schnittlinie und außerhalb der Kontaktfläche mit einer isolierenden Schicht bedeckt ist und/oder,
**dass** sich die Kontaktfläche der Vorderseitenmetallisierung (2) im Wesentlichen über die gesamte Breite der Solarzelle erstreckt.

4. Solarzelle nach einem der vorangegangenen Ansprüche,
**dadurch gekennzeichnet,**
**dass** die Vorderseitenmetallisierung (2) und/oder die Rückseitenmetallisierung (6) mehrere Kontaktflächen aufweisen, die auf der gemeinsamen, senkrecht zur Vorderseite stehenden Schnittfläche liegen.

5. Solarzelle nach einem der vorangegangenen Ansprüche,
**dadurch gekennzeichnet,**
**dass** die Kontaktfläche der Vorderseite über der Kontaktfläche der Rückseite angeordnet ist.

6. Solarzelle nach einem der vorangegangenen Ansprüche,
**dadurch gekennzeichnet,**
**dass** die Vorderseitenmetallisierung (2) als Standardkontaktierungsgitter ausgebildet ist, umfassend mehrere im Wesentlichen parallel angeordnete, linienartige Metallisierungsfinger, mit einer Breite im Bereich von 30 µm bis 200 µm
und mindestens eine als Busbar ausgebildeten Kontakierungsfläche umfassend, welche derart im wesentlichen senkrecht zu den Metallisierungsfingern angeordnet ist, dass sie die Metallisierungsfinger leitend verbindet.

7. Solarzelle nach einem der vorangegangenen Ansprüche,
**dadurch gekennzeichnet,**
**dass** die Solarzelle auf der Rückseite mehrere inselartige Bereiche des ersten Leitfähigkeittyps aufweist, die durch mindestens einen Bereich des zweiten Leitfähigkeittyps voneinander getrennt sind, vorzugsweise,
**dass** jeder inselartige Bereich des ersten Leitfähigkeittyps eine mit diesem Bereich leitend verbundene Metallisierung aufweist, insbesondere eine als Metallisierungsfinger mit einer Breite im Bereich von 30 µm bis 200 µm ausgeführte Metallisierung,
insbesondere,
**dass** die Rückseitenmetallisierung (6) als Standardkontaktierungsgitter ausgebildet ist, umfassend mehrere im Wesentlichen parallel angeordnete, linienartige Metalliserungsfinger, mit einer Breite im Bereich von 30 µm bis 200 µm
und mindestens eine als Busbar ausgebildeten Kontakierungsfläche umfassend, welche derart im wesentlichen senkrecht zu den Metallisierungsfingern angeordnet ist, dass sie die Metallisierungsfinger leitend verbindet und
**dass** zwischen den Metallisierungsfingern und dem Busbar an der Rückseite die inselartigen Bereiche des ersten Leitfähigkeittyps angeordnet sind.

8. Solarzelle nach einem der vorangegangenen Ansprüche,
**dadurch gekennzeichnet,**
**dass** die Ausnehmung an ihren Wänden zumindest teilweise einen Bereich des ersten Leitfähigkeittyps aufweist, welcher derart angeordnet ist, dass er den ersten und den dritten Bereich elektrisch leitend verbindet,
insbesondere,
**dass** die Ausnehmungen zumindest teilweise eine Metallisierung aufweisen, welche den ersten und den dritten Bereich elektrisch leitend verbindet oder lediglich die Leitfähigkeit in der Ausnehmung erhöht.

9. Solarzelle nach einem der vorangegangenen Ansprüche,
**dadurch gekennzeichnet,**
**dass** die Rückseitenmetallisierung (6) einen im Wesentlichen linienförmigen Rückseitenbusbar (7) umfasst und dass der Rückseitenbusbar (7) in etwa auf der gedachten Rückseiten-Schnittlinie liegt und/oder
**dass** die Vorderseitenmetallisierung (2) einen im Wesentlichen linienförmigen Vorderseitenbusbar (3) umfasst und dass der Vorderseitenbusbar (3) auf einer gedachten Vorderseiten-Schnittlinie zwischen der Vorderseite der Solarzelle und der gedachten Ebene liegt.

10. Solarzelle nach einem der vorangegangenen Ansprüche,
**dadurch gekennzeichnet,**
**dass** der zweite Dotierbereich derart angeordnet ist, dass er die Rückseite des Halbleitersubstrates zumindest im Bereich der gedachten Rückseiten-Schnittlinie abdeckt.

11. Solarzellenmodul,
umfassend mindestens zwei Solarzellen mit jeweils einer Vorder- (2) und einer Rückseitenmetallisierung (6) und mindestens einen Zellverbinder (11),
wobei die Solarzellen in dem Modul nebeneinander liegend angeordnet sind und der Zellverbinder (11) die Rückseitenmetallisierung (6) der ersten Solarzelle mit der Vorderseitenmetallisierung (2) der zweiten Solarzelle verbindet,
wobei der Zellverbinder (11) im vertikalen Schnitt im Wesentlichen geradlinig ausgebildet ist,
**dadurch gekennzeichnet,**
**dass** die zwei Solarzellen gemäß einem der vorhergehenden Ansprüche ausgestaltet sind und derart nebeneinander angeordnet sind, dass der Zellverbinder (11) ausgehend von der Kontaktierungsfläche der Rückseitenmetallisierung (6) der ersten Solarzelle im vertikalen Schnitt im Wesentlichen geradlinig zu der Kontaktierungsfläche der Vorderseite der zweiten Solarzelle verläuft und die beiden Kontaktierungsflächen elektrisch leitend verbindet.

12. Verfahren zur Herstellung einer Solarzelle aus einem Halbleiterwafer mit einer Vorder- und einer im Wesentlichen dazu parallelen Rückseite nach einem der Ansprüche 1 bis 11, folgende Verfahrensschritte umfassend:
b-2 Entfernen des Sägeschadens an dem Halbleiterwafer,
b-4 Diffusion von einem ersten Dotierbereich eines ersten Leitfähigkeittyps, wobei der erste Dotierbereich sich im Wesentlichen über die gesamte Vorderseite der Solarzelle erstreckt und
Diffusion von einem dritten Dotierbereich des ersten Leitfähigkeittyps, wobei der dritte Dotierbereich sich teilweise über die Rückseite der Solarzelle erstreckt,
b-7 Aufbringen einer Rückseitenmetallisierung
b-8 Aufbringen einer Vorderseitenmetallisierung, welche die
Vorderseite teilweise bedeckt
wobei die Solarzelle mit Ausnehmungen ausgebildet wird, welche im Wesentlichen senkrecht zu der Vorderseite der Solarzelle stehen und sowohl den ersten, als auch den dritten Bereich durchdringen, wobei der erste und der dritte Bereich durch die Ausnehmung elektrisch leitend verbunden werden,
**dadurch gekennzeichnet,**
**dass** in Schritt b-7 die Rückseitenmetallisierung die Rückseite nur teilweise bedeckend aufgebracht wird,
**dass** bei Aufbringen der Vorderseite eine etwa parallel zur Vorderseite liegende Vorderseitenkontaktfläche ausgebildet wird und bei Aufbringen der Rückseite eine etwa parallel zur Rückseite liegende Rückseitenkontaktfläche ausgebildet wird, wobei Vorder- und Rückseitenkontaktfläche jeweils mindestens 0,5 mm lang und 0,5 mm breit sind und
**dass** die Vorder- und Rückseitenkontaktfläche derart angeordnet werden, dass sie von einer gemeinsamen, senkrecht zur Rückseite stehenden gedachten Ebene durchdrungen werden, und die Solarzelle derart ausgebildet wird, dass an der Rückseite der Solarzelle entlang einer gedachten Rückseiten-Schnittlinie zwischen der Rückseite der Solarzelle und der gedachten Ebene, keine elektrische Verbindung zu dem dritten Dotierbereich und keine elektrische Verbindung zu dem ersten Dotierbereich besteht, so dass an der Rückseite der Solarzelle entlang der Rückseiten-Schnittlinie keine elektrische Kontakt zu dem ersten und zu dem dritten Dotierbereich besteht,
derart, dass ein entlang der Rückseiten-Schnittlinie auf die Rückseite der Solarzelle geführter elektrisch leitender Zellverbinder (11) lediglich mit der Rückseitenmetallisierung (6) und/oder dem zweiten Dotierbereich elektrisch leitend verbunden ist.

13. Verfahren nach Anspruch 12,
**dadurch gekennzeichnet,**
**dass** an der Rückseite der Solarzelle entlang der Rückseiten-Schnittlinie ein Dotierbereich des zweiten Leitfähigkeittyps ausgebildet wird, und/oder
**dass** an der Rückseite der Solarzelle entlang der Rückseiten-Schnittlinie und außerhalb der Rückseitenkontaktfläche die Rückseite mit einer isolierenden Schicht bedeckt wird.

14. Verfahren nach einem der Ansprüche 12 bis 13,
**dadurch gekennzeichnet,**
**dass** in einem Schritt b-1 die Ausnehmungen als Löcher in der Solarzelle erzeugt werden, welche im Wesentlichen senkrecht zur Vorderseite der Solarzelle stehen, wobei die Löcher mittels eines Lasers erzeugt werden, und/oder
**dass** in Schritt b-4 zusätzlich an den Lochwänden ein Dotierbereich des ersten Leitfähigkeittyps erzeugt wird und der dritte Dotierbereich im Bereich der Löcher angeordnet wird, derart, dass erster Dotierbereich und dritter Dotierbereich über den Dotierbereich an den Lochwänden elektrisch miteinander verbunden sind.

15. Verfahren nach einem der Ansprüche 12 bis 14,
**dadurch gekennzeichnet,**
**dass** vor Schritt b-4 eine Diffusionsbarriere auf die Rückseite der Solarzelle aufgebracht wird,
oder
**dass** die in Schritt b-4 diffundierten Dotierbereiche an der Rückseite und/oder der Vorderseite der Solarzelle mittels eines Lasers elektrisch isoliert werden.

## Claims

1. Solar cell, comprising
a semiconductor substrate having a front side and a rear side substantially parallel thereto,
a front-side metallisation (2) and a rear-side metallisation (6)
and
three doped regions having two different conductivity types:
- on the front side of the semiconductor substrate there is arranged a first doped region of a first conductivity type, which first doped region extends over substantially the entire front side,
- on the rear side of the semiconductor substrate there is arranged a second doped region of a second conductivity type opposite to the first conductivity type, which second doped region extends over part of the rear side, and
- on the rear side there is arranged a third doped region of the first conductivity type, which third doped region extends over part of the rear side,
wherein the front-side metallisation (2) is electrically conductively connected to the first doped region and the rear-side metallisation (6) is electrically conductively connected to the second doped region, and
the solar cell has an electrically conductive connection which electrically conductively connects the third doped region to the front-side metallisation (2) and/or to the first doped region,
wherein the solar cell has openings which run substantially perpendicularly to the front side of the solar cell and pass through both the first region and the third region, the first and third regions being electrically conductively connected by the opening, **characterised in that**
the front-side metallisation (2) comprises at least one front-side contact face lying approximately parallel to the front side, and the rear-side metallisation (6) comprises at least one rear-side contact face lying approximately parallel to the rear side, and the front-side contact face and the rear-side contact face are each at least 0.5 mm long and at least 0.5 mm wide,
wherein the front-side and rear-side contact faces are arranged in such a way that a common notional plane running perpendicularly to the rear side passes through them, and
the solar cell is formed in such a way that on the rear side of the solar cell, along a notional rear-side line of intersection between the rear side of the solar cell and the notional plane, there is no electrical connection to the third doped region and no electrical connection to the first doped region, so that on the rear side of the solar cell, along the rear-side line of intersection, there is no electrical contact to the first doped region and to the third doped region,
in such a way that an electrically conductive cell connector (11) guided along the rear-side line of intersection on the rear side of the solar cell is in electrically conductive connection solely with the rear-side metallisation (6) and/or with the second doped region.

2. Solar cell according to claim 1,
**characterised in that**
the rear side of the solar cell is covered with a region of the second conductivity type along the rear-side line of intersection.

3. Solar cell according to either one of the preceding claims,
**characterised in that**
the rear side of the solar cell is covered with an insulating layer along the rear-side line of intersection and outside the contact face and/or
the contact face of the front-side metallisation (2) extends over substantially the entire width of the solar cell.

4. Solar cell according to any one of the preceding claims,
**characterised in that**
the front-side metallisation (2) and/or the rear-side metallisation (6) have a plurality of contact faces which lie on the common area of intersection running perpendicularly to the front side.

5. Solar cell according to any one of the preceding claims,
**characterised in that**
the contact face of the front side is arranged above the contact face of the rear side.

6. Solar cell according to any one of the preceding claims,
**characterised in that**
the front-side metallisation (2) is in the form of a standard contact grid, comprising a plurality of linear metallisation fingers arranged substantially in parallel, having a width in the range of from 30 µm to 200 µm,
and comprising at least one contacting face in the form of a bus bar, which is arranged substantially perpendicular to the metallisation fingers in such a way that it conductively connects the metallisation fingers.

7. Solar cell according to any one of the preceding claims,
**characterised in that**
the solar cell has, on its rear side, a plurality of island-like regions of the first conductivity type which are separated from one another by at least one region of the second conductivity type, preferably,
each island-like region of the first conductivity type has a metallisation in conductive connection with that region, especially a metallisation implemented as metallisation fingers having a width in the range of from 30 µm to 200 µm,
especially,
the rear-side metallisation (6) is in the form of a standard contact grid, comprising a plurality of linear metallisation fingers arranged substantially in parallel, having a width in the range of from 30 µm to 200 µm,
and comprising at least one contacting face in the form of a bus bar, which is arranged substantially perpendicular to the metallisation fingers in such a way that it conductively connects the metallisation fingers, and
the island-like regions of the first conductivity type are arranged between the metallisation fingers and the bus bar on the rear side.

8. Solar cell according to any one of the preceding claims,
**characterised in that**
the opening has on its walls, at least in part, a region of the first conductivity type which is arranged in such a way that it electrically conductively connects the first region and the third region, especially,
the openings have, at least in part, a metallisation which electrically conductively connects the first region and the third region or simply increases the conductivity in the opening.

9. Solar cell according to any one of the preceding claims,
**characterised in that**
the rear-side metallisation (6) comprises a substantially linear rear-side bus bar (7), and the rear-side bus bar (7) lies approximately on the notional rear-side line of intersection and/or
the front-side metallisation (2) comprises a substantially linear front-side bus bar (3), and the front-side bus bar (3) lies on a notional front-side line of intersection between the front side of the solar cell and the notional plane.

10. Solar cell according to any one of the preceding claims,
**characterised in that**
the second doped region is arranged in such a way that it covers the rear side of the semiconductor substrate at least in the region of the notional rear-side line of intersection.

11. Solar cell module,
comprising at least two solar cells each having a front-side metallisation (2) and a rear-side metallisation (6) and at least one cell connector (11),
wherein the solar cells are arranged one next to the other in the module and the cell connector (11) connects the rear-side metallisation (6) of the first solar cell to the front-side metallisation (2) of the second solar cell,
wherein the cell connector (11) is substantially rectilinear in vertical section,
**characterised in that**
the two solar cells are configured in accordance with any one of the preceding claims and are arranged one next to the other in such a way that the cell connector (11), starting from the contacting face of the rear-side metallisation (6) of the first solar cell, in vertical section runs substantially rectilinearly to the contacting face of the front side of the second solar cell and electrically conductively connects the two contacting faces.

12. Method for producing a solar cell comprising a semiconductor wafer having a front side and a rear side substantially parallel thereto according to any one of claims 1 to 11, comprising the following method steps:
b-2 removal of the saw damage on the semiconductor wafer,
b-4 diffusion of a first doped region of a first conductivity type, the first doped region extending over substantially the entire front side of the solar cell
and
diffusion of a third doped region of the first conductivity type, the third doped region extending over part of the rear side of the solar cell,
b-7 application of a rear-side metallisation,
b-8 application of a front-side metallisation which covers part of the front side,
wherein the solar cell is formed with openings which run substantially perpendicularly to the front side of the solar cell and pass through both the first region and the third region, the first and third regions being electrically conductively connected by the opening, **characterised in that**
in step b-7 the rear-side metallisation is applied so as to cover only part of the rear side,
on application of the front side a front-side contact face lying approximately parallel to the front side is formed and on application of the rear side a rear-side contact face lying approximately parallel to the rear side is formed, the front-side and rear-side contact faces each being at least 0.5 mm long and 0.5 mm wide, and
the front-side and rear-side contact faces are arranged in such a way that a common notional plane running perpendicularly to the rear side passes through them, and
the solar cell is formed in such a way that on the rear side of the solar cell, along a notional rear-side line of intersection between the rear side of the solar cell and the notional plane, there is no electrical connection to the third doped region and no electrical connection to the first doped region, so that on the rear side of the solar cell, along the rear-side line of intersection, there is no electrical contact to the first doped region and to the third doped region,
in such a way that an electrically conductive cell connector (11) guided along the rear-side line of intersection on the rear side of the solar cell is in electrically conductive connection solely with the rear-side metallisation (6) and/or with the second doped region.

13. Method according to claim 12,
**characterised in that**
on the rear side of the solar cell a doped region of the second conductivity type is formed along the rear-side line of intersection, and/or
on the rear side of the solar cell the rear side is covered with an insulating layer along the rear-side line of intersection and outside the rear-side contact face.

14. Method according to either one of claims 12 and 13,
**characterised in that**
in a step b-1 the openings are created as holes in the solar cell which run substantially perpendicularly to the front side of the solar cell, the holes being created by means of a laser,
and/or
in step b-4, in addition, a doped region of the first conductivity type is created on the hole walls, and the third doped region is arranged in the region of the holes in such a way that the first doped region and the third doped region are in electrically conductive connection with one another via the doped region on the hole walls.

15. Method according to any one of claims 12 to 14,
**characterised in that**
before step b-4 a diffusion barrier is applied to the rear side of the solar cell,
or
the doped regions diffused in step b-4 on the rear side and/or the front side of the solar cell are electrically isolated by means of a laser.

## Revendications

1. Cellule solaire comportant
un substrat semi-conducteur doté d'un côté avant et d'un côté arrière essentiellement parallèle au côté avant, d'une métallisation (2) du côté avant et d'une métallisation (6) du côté arrière et
trois zones de dopage présentant deux types différents de conductivité :
- sur le côté avant du substrat semi-conducteur est disposée une zone dopée d'un premier type de conductivité qui s'étend essentiellement sur la totalité du côté avant,
- sur le côté arrière du substrat semi-conducteur est disposée une zone dopée d'un deuxième type de conductivité opposé au premier type de conductivité qui s'étend sur une partie du côté arrière et
- sur le côté arrière est disposée une troisième zone dopée du premier type de conductivité qui s'étend sur une partie du côté arrière,
la métallisation (2) du côté avant étant reliée de manière électriquement conductrice à la première zone dopée et la métallisation (6) du côté arrière étant reliée de manière électriquement conductrice à la deuxième zone dopée,
la cellule solaire présentant une liaison électriquement conductrice qui relie de manière électriquement conductrice la troisième zone dopée à la métallisation (2) du côté avant et/ou à la première zone dopée,
la cellule solaire présentant des découpes essentiellement perpendiculaires au côté avant de la cellule solaire et qui traversent à la fois la première et la troisième zone, la première et la troisième zone étant reliées de manière électriquement conductrice par la découpe,
**caractérisée en ce que**
la métallisation (2) du côté avant présente au moins une surface de contact de côté avant située parallèlement au côté avant et la métallisation (6) du côté arrière comporte au moins une surface de contact de côté arrière située essentiellement parallèlement au côté arrière, la surface de contact de côté avant et la surface de contact de côté arrière étant chacune d'une longueur d'au moins 0,5 mm et d'une largeur d'au moins 0,5 mm, la surface de contact de côté avant et la surface de contact de côté arrière étant disposées de telle sorte qu'elles soient traversées par un plan imaginaire commun perpendiculaire au côté arrière et
**en ce que** la cellule solaire est configurée de telle sorte qu'aucune liaison électrique avec la troisième zone dopée et aucune liaison électrique avec la première zone dopée ne soit établie sur le côté arrière de la cellule solaire suivant une ligne de coupe imaginaire de côté arrière entre le côté arrière de la cellule solaire et le plan imaginaire, de telle sorte qu'aucun contact électrique ne soit établi avec la première et la troisième zone dopée sur le côté arrière de la cellule solaire le long de la ligne de coupe de côté arrière, de telle sorte qu'un raccord de cellule (11) électriquement conducteur s'étendant sur le côté arrière de la cellule solaire le long de la ligne de coupe de côté arrière ne soit relié de manière électriquement conductrice qu'à la métallisation (6) du côté arrière et/ou à la deuxième zone dopée.

2. Cellule solaire selon la revendication 1, **caractérisée en ce que** le côté arrière de la cellule solaire est couvert par une zone du deuxième type de conductivité le long de la ligne de coupe du côté arrière.

3. Cellule solaire selon l'une des revendications précédentes, **caractérisée en ce que** le côté arrière de la cellule solaire est recouvert par une couche isolante le long de la ligne de coupe du côté arrière et à l'extérieur de la surface de contact et/ou **en ce que** la surface de contact de la métallisation (2) du côté avant s'étend essentiellement sur toute la largeur de la cellule solaire.

4. Cellule solaire selon l'une des revendications précédentes, **caractérisée en ce que** la métallisation (2) du côté avant et/ou la métallisation (6) du côté arrière présentent plusieurs surfaces de contact situées sur la surface de coupe commune perpendiculaire au côté avant.

5. Cellule solaire selon l'une des revendications précédentes, **caractérisée en ce que** la surface de contact du côté avant est disposée au-dessus de la surface de contact du côté arrière.

6. Cellule solaire selon l'une des revendications précédentes, **caractérisée en ce que** la métallisation (2) du côté avant est configurée comme grille de contact standard comprenant plusieurs doigts de métallisation en forme de lignes disposées essentiellement en parallèle les unes aux autres et d'une largeur de l'ordre de 30 µm à 200 µm et au moins une surface de contact configurée comme barre de bus, disposée essentiellement à la perpendiculaire des doigts de métallisation de manière à relier de manière conductrice les doigts de métallisation.

7. Cellule solaire selon l'une des revendications précédentes, **caractérisée en ce que** la cellule solaire présente sur le côté arrière plusieurs zones du premier type de conductivité en forme d'îlots, séparées les unes des autres par au moins une zone du deuxième type de conductivité, et de préférence **en ce que** chaque partie en forme d'îlot du premier type de conductivité présente une métallisation reliée de manière conductrice à cette zone, en particulier une métallisation réalisée sous la forme d'un doigt de métallisation d'une largeur de l'ordre de 30 µm à 200 µm, en particulier **en ce que** la métallisation (6) du côté arrière est configurée comme grille de contact standard comprenant plusieurs doigts de métallisation en forme de lignes disposées essentiellement en parallèle les unes aux autres et d'une largeur de l'ordre de 30 µm à 200 µm et au moins une surface de contact configurée comme barre de bus, disposée essentiellement à la perpendiculaire des doigts de métallisation de manière à relier de manière conductrice les doigts de métallisation et **en ce que** les zones en forme d'îlot du premier type de conductivité sont disposées sur le côté arrière entre les doigts de métallisation et la barre de bus.

8. Cellule solaire selon l'une des revendications précédentes, **caractérisée en ce que** la découpe présente sur au moins une partie de ses parois une zone du premier type de conductivité disposée de telle sorte qu'elle relie de manière électriquement conductrice la première et la troisième zone, et en particulier **en ce que** les découpes présentent au moins en partie une métallisation qui relie de manière électriquement conductrice la première et la troisième zone ou qui augmente seulement la conductivité dans la découpe.

9. Cellule solaire selon l'une des revendications précédentes, **caractérisée en ce que** la métallisation (6) du côté arrière comporte une barre de bus (7) de côté arrière, de forme essentiellement linéaire, et **en ce que** la barre de bus (7) de côté arrière est située sensiblement sur la ligne de coupe imaginaire du côté arrière et/ou **en ce que** la métallisation (2) du côté avant comporte une barre de bus (3) de côté avant de forme essentiellement linéaire et **en ce que** la barre de bus (3) de côté avant est située sur une ligne de coupe imaginaire de côté avant, entre le côté avant de la cellule solaire et le plan imaginaire.

10. Cellule solaire selon l'une des revendications précédentes, **caractérisée en ce que** la deuxième zone dopée est disposée de telle sorte qu'elle couvre le côté arrière du substrat semi-conducteur au moins au niveau de la ligne de coupe imaginaire du côté arrière.

11. Module de cellule solaire comprenant au moins deux cellules solaires dotées au moins d'une métallisation (2) du côté avant et d'une métallisation (6) du côté arrière ainsi que d'au moins un raccord de cellule (11),
les cellules solaires étant disposées l'une à côté de l'autre dans le module et le raccord de cellule (11) reliant la métallisation (6) du côté arrière de la première cellule solaire à la métallisation (2) du côté avant de la deuxième cellule solaire,
le raccord de cellule (11) étant configuré essentiellement en ligne droite en coupe verticale, **caractérisé en ce que**
les deux cellules solaires sont configurées selon l'une des revendications précédentes et sont disposées l'une à côté de l'autre de telle sorte que le raccord de cellule (11) partant de la surface de contact de la métallisation (6) du côté arrière de la première cellule solaire s'étend essentiellement en ligne droite en coupe verticale en direction de la surface de contact du côté avant de la deuxième cellule solaire, et relie de manière électriquement conductrice les deux surfaces de contact.

12. Procédé de fabrication d'une cellule solaire constituée d'une galette semi-conductrice dotée d'un côté avant et d'un côté arrière essentiellement parallèle au côté avant, selon l'une des revendications 1 à 11, le procédé comportant les étapes suivantes :
b-2 élimination des défauts de sciage de la galette semi-conductrice,
b-4 diffusion d'une première zone dopée d'un premier type de conductivité, la première zone dopée s'étendant essentiellement sur tout le côté avant de la cellule solaire,
diffusion d'une troisième zone dopée du premier type de conductivité, la troisième zone dopée s'étendant en partie sur le côté arrière de la cellule solaire,
b-7 application d'une métallisation sur le côté arrière,
b-8 application d'une métallisation sur le côté avant qui recouvre partiellement le côté avant,
la cellule solaire étant configurée avec des découpes essentiellement perpendiculaires au côté avant de la cellule solaire et qui traversent à la fois la première et la troisième zone, la première et la troisième zone étant reliées de manière électriquement conductrice par la découpe,
**caractérisé en ce que**
la métallisation sur le côté arrière est appliquée à l'étape b-7 de manière à recouvrir uniquement partiellement le côté arrière,
**en ce que** lors de l'application du côté avant, une surface de contact de côté avant située sensiblement parallèlement au côté avant est formée et lors de l'application du côté arrière, une surface de contact de côté arrière située sensiblement en parallèle au côté arrière est formée, la surface de contact de côté avant et la surface de contact de côté arrière ayant chacune une longueur d'au moins 0,5 mm et une largeur d'au moins 0,5 mm,
**en ce que** la surface de contact de côté avant et la surface de contact de côté arrière sont disposées de telle sorte qu'elles sont traversées par un plan imaginaire commun perpendiculaire au côté arrière et
**en ce que** la cellule solaire est configurée de telle sorte est configurée de telle sorte qu'aucune liaison électrique avec la troisième zone dopée et aucune liaison électrique avec la première zone dopée ne soit établie sur le côté arrière de la cellule solaire suivant une ligne de coupe imaginaire de côté arrière entre le côté arrière de la cellule solaire et le plan imaginaire, de telle sorte qu'aucun contact électrique ne soit établi avec la première et la troisième zone dopée sur le côté arrière de la cellule solaire le long de la ligne de coupe de côté arrière, de telle sorte qu'un raccord de cellule (11) électriquement conducteur s'étendant sur le côté arrière de la cellule solaire le long de la ligne de coupe de côté arrière ne soit relié de manière électriquement conductrice qu'à la métallisation (6) du côté arrière et/ou à la deuxième zone dopée.

13. Procédé selon la revendication 12, **caractérisé en ce qu'**une zone dopée du deuxième type de conductivité est formée sur le côté arrière de la cellule solaire le long de la ligne de coupe du côté arrière et/ou **en ce que** sur le côté arrière de la cellule solaire, le côté arrière est recouvert d'une couche isolante le long de la ligne de coupe du côté arrière et à l'extérieur de la surface de contact de côté arrière.

14. Procédé selon l'une des revendications 12 et 13, **caractérisé en ce que** dans une étape b-1, les découpes sont formées sous la forme de trous ménagés dans la cellule solaire et essentiellement perpendiculaires au côté avant de la cellule solaire, les trous étant formés au moyen d'un laser et/ou **en ce qu'**à l'étape b-4, une zone dopée du premier type de conductivité est formée en supplément sur la paroi des trous, et la troisième zone dopée est disposée au niveau des trous de telle sorte que la première zone dopée et la troisième zone dopée soient reliées de manière électriquement conductrice par la zone dopée des parois des trous.

15. Procédé selon l'une des revendications 12 à 14, **caractérisé en ce qu'**avant l'étape b-4, une barrière à la diffusion est appliquée sur le côté arrière de la cellule solaire ou **en ce que** les zones dopées diffusées à l'étape b-4 sur le côté arrière et/ou sur le côté avant de la cellule solaire sont isolées électriquement au moyen d'un laser.
